# FASCICULE DE BREVET EUROPEEN

(11) **EP 0 954 865 B1**
(45) Date de publication et mention de la délivrance du brevet: **16.05.2001**
(21) Numéro de dépôt: 98903102.6
(22) Date de dépôt: 22.01.1998
(51) Int. Cl.: G11C 16/06

(54) **PROCEDE DE PROGRAMMATION D'UNE MEMOIRE DE TYPE EPROM-FLASH**
VERFAHREN ZUM PROGRAMMIEREN EINES FLASH-EPROM-SPEICHERS
METHOD FOR PROGRAMMING AN EPROM-FLASH TYPE MEMORY

(30) Priorité: 22.01.1997 FR 9700642
(43) Date de publication de la demande: 10.11.1999
(73) Titulaire: STMicroelectronics S.A., 94250 Gentilly (FR)
(72) Inventeur: DEVIN, Jean, F-13100 Aix-en-Provence (FR); BRIGATI, Alessandro, F-13100 Aix-en-Provence (FR); LECONTE, Bruno, F-13790 Rousset (FR)
(74) Mandataire: Ballot, Paul
(86) Numéro de dépôt international: FR9800111
(87) Numéro de publication internationale: WO9833187

(56) Documents cités:
- EP-A- 0 459 794
- EP-A- 0 704 851
- WO-A-95/07534
- GB-A- 2 288 895
- US-A- 5 355 347
- US-A- 5 363 330
- US-A- 5 365 486

## Description

La présente invention se rapporte à un procédé de programmation pour une mémoire de type EPROM-Flash.

Dans ce type de mémoire, chaque élément de stockage d'information, ou cellule mémoire, est constitué par un transistor MOS à grille flottante qui peut se trouver dans deux états. Ainsi, dans le cas d'un transistor MOS à canal N, dans un premier état dit effacé, aucune charge négative ou bien même une charge positive est piégée sur la grille flottante. Un canal de conduction peut alors exister entre source et drain de ce transistor. Dans un deuxième état dit programmé, des électrons sont piégés sur la grille flottante. Ils empêchent donc la création d'un canal de conduction dans le substrat entre source et drain. Dans ce cas, le transistor est bloqué et se comporte comme un circuit ouvert.

Dans une mémoire de type EPROM-Flash, le passage d'un électron du canal de conduction vers la grille flottante se fait par un procédé dit d'électrons chauds. Dans ce but, des tensions élevées sont appliquées entre la grille de commande et le drain de ce même transistor à grille flottante alors que la source est connectée à la masse. Ces tensions permettent le passage d'électrons de très haute énergie (électrons chauds), provenant du canal ainsi créé, vers la grille flottante. Les électrons sont alors piégés dans la grille flottante et constituent une information. L'enlèvement des charges, ou effacement, est provoqué par un effet tunnel.

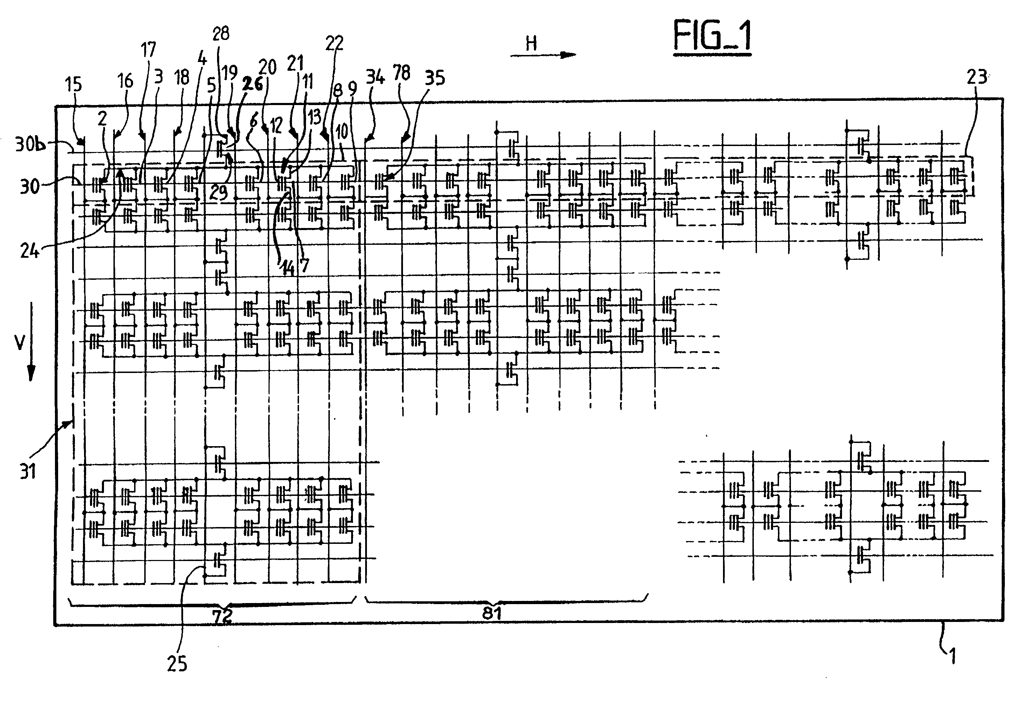

Un plan mémoire est composé de mots comportant, dans un exemple, huit cellules pouvant mémoriser chacune une information binaire (à savoir l'un des deux états précédents). La figure 1 représente en partie une telle architecture. Ces cellules peuvent être sélectionnées individuellement. Elles sont arrangées en rangées et en colonnes.

Dans une architecture classique, tous les transistors à grille flottante des cellules mémoires d'un même mot, c'est-à-dire d'un même octet dans l'exemple, ont leur grille de commande reliée à une même source de tension par une ligne de mots et leur source reliée à une même électrode principale d'un transistor de sélection par une connexion. Ce transistor de sélection autorise ou non la polarisation de la source des transistors à grille flottante du mot. Une telle architecture avec un tel transistor de sélection est décrite dans la demande de brevet EP-A-0 704 851 conforme au préambule de la revendication 1. L'intérêt du transistor de sélection est d'éviter la déplétion du transistor à grille flottante d'une cellule, et d'assurer ainsi une uniformité parfaite de la tension de seuil des cellules qui ont fait l'objet d'un effacement.

Ce même transistor de sélection a son autre électrode principale, drain ou source, reliée à une connexion verticale de source de mots qui sont adjacents verticalement. Les mots adjacents verticalement se trouvent donc sur des rangées différentes. Ce transistor de sélection permet de polariser ou non les sources communes des transistors à grille flottante d'un même mot. Ces mots ont Q octets. Si Q = 1, le mot a un octet. Les grilles de commande des transistors à grille flottante des cellules des mots dans une même rangée sont connectées à une même ligne de mot. De plus, les grilles de commande des transistors de sélection des mots d'une même rangée sont reliées à une même ligne de sélection de mots recevant un signal de sélection associé, souvent identique au signal appliqué sur la ligne de mots.

Avec une telle architecture, il existe des contraintes qui limitent la programmation de plusieurs cellules mémoires d'un même mot au cours d'un même cycle de programmation. En effet, lors de la programmation, la grille de commande de chaque cellule d'une même rangée est soumise à une tension élevée. Le drain du transistor à grille flottante d'une cellule sélectionnée pour être programmée est porté à une tension suffisamment élevée pour accélérer les charges dans un canal. La source de ce transistor à grille flottante est portée à la masse. Cette tension élevée permet aux charges d'acquérir une énergie élevée, et produit un courant important à travers ce canal (500 µA/cellule). Ainsi pour un octet, le courant produit lors de cette programmation peut être de l'ordre de 4 mA. Ce courant est beaucoup trop élevé car la connexion verticale de source est limitée en taille et ne peut supporter un courant si important. Par exemple, si beaucoup de cellules étaient programmées dans le même mot, le courant produit provoquerait un arrachement du film de métal de la connexion verticale de source par un phénomène d'électromigration. En outre, ce courant qui provoque par la même occasion une élévation du potentiel de source des transistors à grille flottante du mot réduit l'efficacité de la programmation.

Dans le document U.S. 5,355,347, on propose une mémoire en technologie EEPROM comportant des moyens pour la programmation simultanément au cours d'un même cycle de programmation, d'une unique cellule dans plusieurs mots différents afin d'accélérer la programmation. Des moyens équivalents sont aussi proposés dans le document U.S. 5,363,330. Cependant, les mémoires EEPROM sont programmées par effet tunnel et ne comportent pas de transistor de sélection commun aux cellules d'un même mot. Ces mémoires ne présentent pas de ce fait l'inconvénient précité de la mémoire Flash-EEPROM dont l'architecture a été décrite ci-dessus.

La présente invention a pour but de remédier à cet inconvénient. A cet effet, l'invention propose un procédé de programmation d'une mémoire de type EPROM-Flash comportant des mots de cellules mémoires arrangées en rangées et en colonnes, dans lesquelles un transistor à grille flottante agit comme organe de mémorisation, les transistors à grille flottante des cellules mémoires d'un même mot ayant leur grille de commande reliée à une même connexion de ligne de mots et leur source reliée à une même électrode principale d'un transistor de sélection dont l'autre électrode principale est reliée à une connexion verticale de source de mots. Selon ce procédé, au cours d'un même cycle de programmation, on programme simultanément M cellules mémoires dans N mots différents, où M est inférieur au nombre P de cellules mémoires d'un mot, et où M, N et P sont des nombres entiers.

De ce fait, le courant sur les connexions verticales de source sollicitées est proportionnel à M. De préférence M est égal à l'unité (M = 1). Cette solution permet de réduire considérablement le courant dans chaque mot, et permet donc un potentiel moindre à la source des transistors à grille flottante du mot. De plus, dans l'invention, en même temps qu'on programme une cellule d'un mot, on programme une cellule d'un autre mot. La programmation de N mots de P bits se fait alors par exemple en P/M cycles.

Selon d'autres caractéristiques avantageuses de l'invention, prises isolément ou en combinaison:
- les N mots différents appartiennent à une même rangée de cellules mémoires;
- M est différent de l'unité, par exemple égal à deux ou à quatre si P est égal à huit;
- on programme toutes les cellules mémoires d'un mot déterminé au cours de P/M cycles de programmation successifs;
- les M cellules mémoires simultanément programmées dans les N mots différents sont des cellules de même rang dans lesdits mots.

Pour arriver à ce résultat, l'architecture de la mémoire a été adaptée de façon à ce que des lignes de bits de cellules de mêmes rang, et qui sont à programmer dans des mots voisins, soient reliées ensemble.

Par ailleurs, une programmation des cellules d'un mot est normalement précédée d'un effacement des cellules de ce mot. Or lors d'un effacement d'un mot sélectionné, une forte tension négative, de l'ordre de - 6V est appliquée par la ligne de mot sur les grilles de commande des transistors à grille flottante de ce mot. La tension appliquée aux sources des transistors à grille flottante de ce même mot est de l'ordre de 10V. Un problème se présente alors pour un transistor à grille flottante d'une cellule se situant sur une même rangée mais qui n'a pas été sélectionnée. Il reçoit en effet sur sa grille de commande la même tension négative de ce premier mot. Même s'il ne reçoit pas la haute tension sur sa source, cette situation provoque parfois un effacement partiel de cette cellule dans ce mot non sélectionné pour la programmation. C'est-à-dire, la tension négative élimine des charges sur sa grille flottante. Ceci provoque à terme une lecture erronée de ce mot.

La présente invention propose de résoudre ce deuxième problème par une séquence d'opérations particulière à effectuer. On commence par programmer toutes les cellules de la mémoire d'une même rangée. Ensuite, on les efface toutes. On vérifie à ce moment là si des cellules n'ont pas subi une déplétion en raison des tensions négatives appliquées lors des effacements. Si c'est le cas, on les reprogramme légèrement afin de mettre leur tension de seuil à un niveau identique à celui des autres cellules mémoires effacées.

On commence ensuite à programmer conformément à l'invention à savoir par exemple un bit sur huit simultanément dans huit mots différents. Après avoir effectué toutes ces opérations, une dernière séquence d'opérations est réalisée, dites opérations de rafraîchissement. Elle consiste à vérifier si certaines cellules non sélectionnées appartenant à la même rangée que la cellule programmée, ont subi du fait de la tension négative appliquée pendant la phase d'effacement un léger effacement ou plus précisément vérifier si ces cellules programmées ont perdu des charges sur leur grille flottante. Si c'est le cas, on reprogramme (on dit qu'on rafraîchit) ces cellules par une nouvelle étape de programmation.

Pour résumer, la programmation d'un mot déterminé de la mémoire comporte les opérations ou étapes suivantes:
- sélection de toutes les cellules du mot ;
- programmation de toutes lesdites cellules sélectionnées à un même niveau de tension de seuil;
- effacement de toutes lesdites cellules sélectionnées;
- vérification d'une éventuelle déplétion de certaines desdites cellules sélectionnées;
- si tel est le cas, reprogrammation légère de ces cellules sélectionnées déplétées afin d'amener leur tension de seuil à un niveau identique à celui des autres cellules effacées;
- programmation des cellules sélectionnées à programmer au cours de P/M cycles de programmation.

De plus, les grilles de commande des transistors à grille flottante des cellules mémoires d'une même rangée étant connectées à une même ligne de mots et les grilles de commande des transistors de sélection des mots d'une même rangée étant connectées à une même ligne de sélection de mots, la programmation comporte en outre les ultimes opérations suivantes, dites opérations de rafraîchissement:
- vérification d'une éventuelle perte de charge des cellules mémoires non sélectionnées de la même rangée;
- et, si tel est le cas, reprogrammation légère de ces cellules mémoires afin de ramener leur tension de seuil à leur niveau précédent.

D'autres caractéristiques et avantages de la présente invention apparaîtront à la lecture de la description de divers modes de réalisation. Cette description est faite ci-après avec référence aux dessins ci-annexés dans lesquels:
- la figure 1 représente schématiquement le circuit d'une mémoire du type EPROM-Flash organisée en mots de 8 cellules de l'état de la technique;
- la figure 2 représente schématiquement une rangée de mots de la mémoire EPROM-Flash de la figure 1 munie d'un circuit de polarisation associé à un multiplexeur conforme à la présente invention;
- la figure 3 représente schématiquement une vue d'ensemble des circuits périphériques de la mémoire EPROM-Flash comportant notamment le circuit de polarisation et son multiplexeur associé.

Dans la description, et les dessins les mêmes éléments portent les mêmes références.

Sur la figure 1 on a représenté une mémoire 1 de type EPROM-Flash comportant des cellules 2 à 9 organisées en mots tel que le premier mot 10. Dans l'exemple, les mots de la mémoire comportent donc 8 cellules mémoires (P = 8). C'est pourquoi dans la suite, on utilisera parfois le terme "octet" pour désigner un mot de cellules mémoires.

Les cellules mémoires, par exemple la cellule 7, comportent un transistor à grille flottante agissant comme organe de mémorisation dans les cellules (les cellules et les transistors à grille flottante respectifs porteront les mêmes indices tout le long de la description). Ce transistor 7 comporte une grille flottante 11, une grille de commande 12 et deux électrodes principales respectivement 13 et 14.

Les électrodes de grille de commande 12 du premier mot 10 sont connectés à une même connexion de ligne de mot 30. L'électrode principale de drain 14 des transistors 2 à 9 des cellules du premier mot 10 est reliée à une connexion de ligne de bits différenciée respectivement 15 à 22 de ce mot. L'autre électrode principale 13, à savoir l'électrode de source, des transistors 2 à 9 d'un premier mot 10 est reliée à une connexion 24 de source de ce mot. Cette connexion 24 est elle-même reliée à une connexion verticale 25 de source par l'intermédiaire d'un transistor de sélection 26. Ce transistor de sélection 26 comporte une grille de commande 27 et deux électrodes principales respectivement 28 et 29. L'électrode principale 28 est reliée à la connexion verticale 25 de source. L'électrode 29 est reliée à la connexion 24 de source du mot 10. Le transistor 26 reçoit sur sa grille de commande un signal de sélection de mot acheminé par une connexion 30b.

La mémoire 1 est constituée d'ensembles verticaux ou colonnes 31 de mots tels que le mot 10, disposés verticalement, de constitution identique au mot 10. Les électrodes de drain de transistors à grille flottante de cellules des mots d'une même colonne telles que la colonne 31 sont reliées aux mêmes lignes de bits, telles que les lignes de bit 15 à 22 du premier mot 10. La connexion verticale 25 de source est commune aux mots d'une même colonne telle que la colonne 72. Deux mots adjacents verticalement sont deux mots situés côte à côte, avec aucun autre mot entre eux, sur une même verticale V montrée sur la figure.

La mémoire 1 est également constituée d'ensembles horizontaux ou rangées de mots tels que le mot 10, disposés horizontalement. Les électrodes de grille de commande de transistors à grille flottante de cellules des mots d'une même rangée telle que la rangée 23 sont reliées à une même ligne de mot telle que la ligne de mots 30 du premier mot 10. Deux mots adjacents horizontalement sont deux mots situés côte à côte, avec aucun autre mot entre eux, sur une même ligne horizontale H montrée sur la figure.

L'ensemble de ces mots disposés verticalement et horizontalement détermine une matrice.

Lors d'une programmation d'une cellule mémoire, on fait monter la tension de la ligne de mots 30 et de la connexion 30b à 12V. Au moyen d'un circuit de polarisation, on porte une ligne de bits sélectionnée, telle que 15 à 22, à laquelle est connectée la cellule à programmer, à une tension de 6V. La connexion 25 est reliée alors à la masse, ce qui met toutes les sources des transistors à grille flottante du mot comportant la cellule sélectionnée à la masse par conduction à travers le transistor de sélection 26. Pour la programmation simultanée de plusieurs cellules mémoires d'un même mot, ceci provoquerait la création d'un courant trop fort endommageant la connexion 25 et limitant l'efficacité de la programmation.

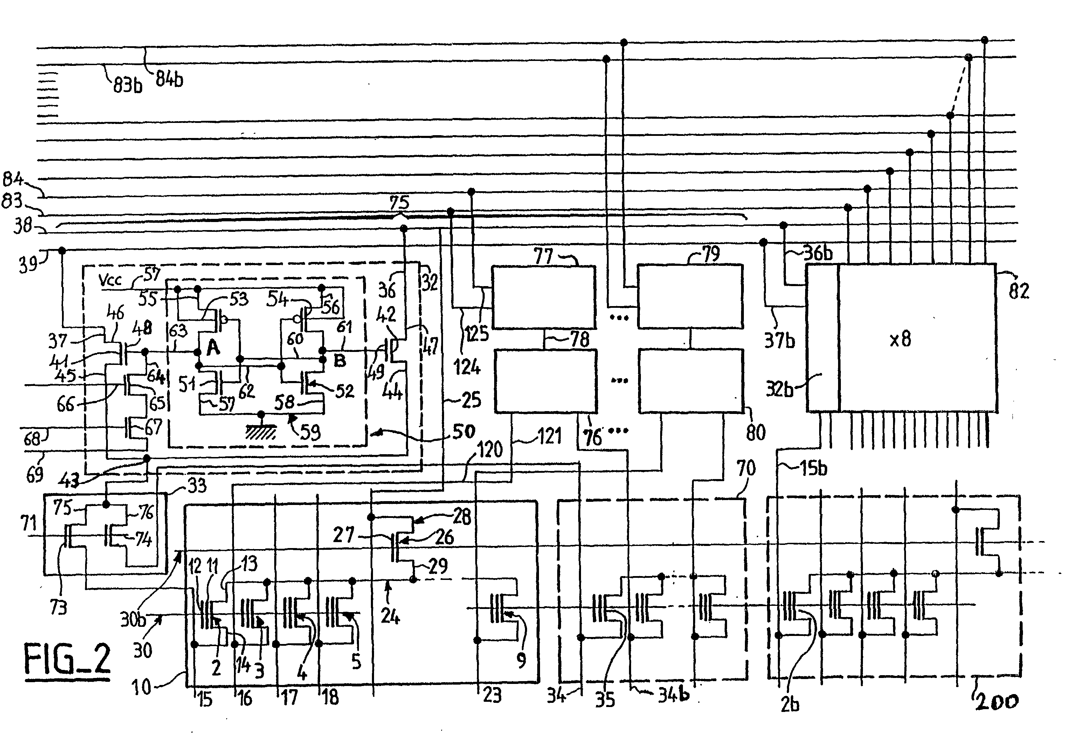

On décrit maintenant en référence à la figure 2 un mode de réalisation d'une mémoire mettant en oeuvre le procédé de programmation selon l'invention. La figure 2 montre une rangée de la matrice de la mémoire 1. Un circuit de polarisation 32, et dans un mode particulier par l'intermédiaire d'un multiplexeur 33, relie conformément à l'invention une ligne de bits 15 à deux connexions communes de programmation 38, 39 par deux connexions de liaison respectivement 36 et 37.

Le principe est qu'une ligne de bits, telle que 15 d'une cellule 2, d'un rang donné d'un premier mot 10, et au moins une ligne de bits telle que 15b d'une cellule mémoire 2b, dans au moins un deuxième mot 200, de préférence une cellule de même rang dans le mot, sont reliées aux deux mêmes connexions communes de programmation, 38 et 39, respectivement par l'intermédiaire de circuits de polarisation différents 32 et 32b. Le circuit 32b est relié aux connexions communes de programmation 38, 39 par deux connexions de liaison respectivement 36b et 37b.

Ainsi, au moins une cellule (et M cellules dans le cas général) dans deux mots différents (dans N mots différents dans le cas général), sont programmées en même temps, c'est-à-dire, simultanément, au cours d'un même cycle de programmation. Les premier et deuxième mots ci-dessus appartiennent de préférence à la même rangée de la matrice de la mémoire, car ils peuvent ainsi être sélectionnés simultanément par l'intermédiaire de la même ligne de mot 30 lors d'une programmation. Le décodage des lignes de mots des cellules de la matrice de la mémoire est ainsi plus simple. Cependant, d'autres dispositions sont envisageables.

De plus, les premier et deuxième mots ci-dessus peuvent être des mots adjacents horizontalement. Cependant, dans le mode de réalisation décrit ci-dessous, cela n'est pas le cas. En effet, ainsi qu'il va maintenant être décrit, les seize lignes de bits de deux mots adjacents horizontalement tels que les mots 10 et 70, sont associées deux à deux à huit circuits de polarisation tels que le circuit 32. Ainsi, le circuit 32 sert aussi bien pour la programmation des huit cellules 2 à 9 du mot 10 que pour la programmation des huit cellules du mot 70, selon l'état du multiplexeur 33. Ceci permet de limiter le nombre de circuits de polarisation nécessaires dans la mémoire. Ces circuits prennent en effet beaucoup de place sur le substrat de polysilicium dopé.

Le circuit de polarisation 32 comporte deux entrées de tension de polarisation correspondant respectivement aux connexions de liaison 36 et 37, et une sortie de tension de polarisation correspondant à une connexion de distribution 43. Cette sortie 43 est reliée à l'entrée d'un multiplexeur 33.

Le multiplexeur 33 comporte deux transistors 73, 74 dont l'un 73 est de type P, l'autre 74 est de type N. La sortie 43 est connectée d'une part à une électrode principale 75 du transistor 73 et d'autre part à l'électrode principale 76 du transistor 74. Les deux autres électrodes principales de ces deux transistors 73 et 74 sont reliées respectivement à une connexion de ligne de bits telle que 15 du mot 10 et 34 du mot 70. On expliquera le fonctionnement de ce multiplexeur optionnel plus loin.

Le circuit 32 comporte deux transistors de polarisation 41 et 42. La connexion 43 de distribution est reliée à des premières électrodes principales 44 et 45 de ces deux transistors 41 et 42. Les autres électrodes principales 46 et 47 de ces deux transistors 41 et 42 sont reliées respectivement aux deux connexions de liaison 37 et 36.

Des électrodes 48, 49 de grilles de commande de ces transistors respectivement 41 et 42 sont connectées à un circuit 50 de délivrance de la donnée à programmer. Ce circuit 50 de délivrance est un circuit de mémorisation pour mémoriser une valeur et une valeur complémentaire d'une donnée binaire à programmer.

Ce circuit de mémorisation comporte, dans un exemple, quatre transistors dont deux de type N respectivement 51 et 52 et deux de type P respectivement 53 et 54 montés ensemble en trigger de SCHMITT. Les deux transistors 53 et 54 ont une de leurs électrodes principales, respectivement 55 et 56, reliée à une connexion 57, elle-même reliée à une source de tension d'alimentation Vcc. Ces transistors respectivement 53 et 54 sont en série par leur autre électrode principale avec les deux autres transistors respectivement 51 et 52. Les points milieux des couples de transistors 51, 53 et 52, 54 sont dénommés bornes A et B. Les autres électrodes principales 57 et 58 des deux transistors 51 et 52 sont reliées à une connexion 59 reliée à la masse.

Les électrodes de grille de commande des deux transistors 53 et 54 sont reliées respectivement aux électrodes de grille de commande des deux transistors 51 et 52. Ces liaisons sont elles-mêmes reliées aux bornes respectivement B et A par des connexions respectivement 60 et 62. On relie la borne B à l'électrode de grille de commande 49 du transistor 42 par la connexion 61. De même, on relie la borne A à l'électrode de grille de commande 48 du transistor de polarisation 41 par la connexion 63. Les deux connexions 61 et 63 constituent les deux sorties du circuit 50 de délivrance permettant de commander en opposition les transistors 41 et 42.

Pour conduire la donnée à l'intérieur du circuit 50, on force la borne A à un potentiel désiré par une chaîne de transistors 65 et 67 en série. La connexion 63 est reliée à l'électrode principale 64 du transistor 65. Le transistor 65 est relié en série par son autre électrode principale au transistor 67. Le transistor 67 comporte une grille de commande 68 et une autre électrode principale 69. La donnée à programmer est appliquée sur l'électrode principale 69 du transistor 67. La grille 68 commande le passage ou non de la donnée à programmer. Le transfert des données dans les circuits 50 se produit au moment de l'application d'un signal de cadencement sur la connexion 68. Toutes les connexions 68 des différents circuits de polarisation 32 sont reliées entre elles. L'électrode 66 du transistor 65 est reliée à une sortie d'un décodeur de ligne de bits.

Préalablement à la programmation on impose par les connexions 66 et 68 des tensions utiles à sélectionner et à conditionner certains des circuits 50 de délivrance de la mémoire. Les circuits 50 qui sont sélectionnés reçoivent une haute tension sur la connexion 66. Pour ceux qui sont sélectionnés, la connexion 69 est portée à la haute tension ou à zéro selon la valeur de la donnée à programmer.

Le circuit 50 délivre la donnée à programmer. Le circuit 50 délivre sur ses deux sorties 61 et 63 deux états logiques complémentaires. Le circuit de polarisation 32 transmet en conséquence à sa sortie 43 une des deux tensions admises sur ses deux entrées 36 et 37. On programme la donnée à programmer dans la cellule 2 en appliquant sur les deux connexions communes de programmation 38 et 39 un couple de tensions traduisant une préparation à la programmation. Dans un exemple, ce couple de tension est de 6 volts portés sur la connexion 38 et de 2 volts portés sur la connexion 39. Les circuits de polarisation tels que le circuit 32 qui sont reliés à des cellules à ne pas programmer (pour l'instant) reçoivent un couple de tensions traduisant une inhibition à la programmation. Dans un exemple, ce couple de tensions d'inhibition est de 2 volts et 2 volts, portés sur les autres connexions communes telles que 83 et 84.

Dans un exemple il y a huit couples de connexions communes tels que 38, 39. Pour chaque mot, on prévoit huit circuits de polarisation tels que le circuit 32, recevant chacun un de ces couples de connexions communes sur ses deux entrées respectives. Les deux entrées du premier circuit de polarisation 32 sont reliées au premier couple de connexions communes 38, 39. Les deux entrées 124 et 125 d'un deuxième circuit de polarisation 77 sont connectées au deuxième couple de connexions communes 83 et 84. Le circuit 77 permet de polariser sélectivement deux lignes de bits 16 ou 34b suivant la valeur de la commande reçue par son multiplexeur associé 76. Les multiplexeurs sont tous commandés par le signal transmis sur la connexion 71. La ligne de bits 16 est adjacente horizontalement à la ligne de bits 15, tout comme la ligne de bits 34b est adjacente horizontalement à la ligne de bits 34. Les deux entrées d'un huitième circuit de polarisation 79 sont reliées au huitième couple de connexions communes 83b, 84b. Ces huit circuits appartiennent à un premier groupe 75 de circuits de polarisation.

Ainsi qu'il a été exposé ci-dessus, un tel groupe de huit circuits de polarisation est utilisé pour la programmation sélective des cellules de deux mots, de préférence adjacents horizontalement, tels que les mots 10 et 70. Dit autrement, le groupe 75 de ces huit circuits de polarisation permet de polariser deux mots 10 et 70 d'une même rangée de la matrice de la mémoire.

Un autre groupe 82 de huit circuits de polarisation est connecté dans les mêmes conditions aux connexions communes de programmation 38, 39, 83, 84 jusqu'à 83b, 84b. Ce groupe 82 comporte seize sorties représentant les sorties des huit multiplexeurs et seize entrées connectées aux huit connexions communes de programmation.

Chaque circuit de polarisation de même rang, dans le groupe 82, qu'un circuit de polarisation du groupe 75 a ses deux entrées telles que 36 et 37 connectées à un même couple de connexions communes.

Pour la programmation d'une cellule, un seul couple de connexions communes est porté au couple de tension de programmation (6 volts, 2 volts). Tous les autres sont portés au couple de tension d'inhibition (2V, 2V). Il y a autant (N) de groupes reliés en même temps aux mêmes connexions communes qu'il y a de mots comprenant des cellules qu'on veut programmer en même temps.

Pour programmer toutes les cellules du mot 10 on porte successivement les connexions communes respectivement 38 et 39 puis 83, 84, ..., 83b, 84b au couple de tensions de programmation (6V, 2V), toutes les autres connexions étant portées au couple de tensions d'inhibition (2V, 2V). Ainsi de suite jusqu'à 83b, 84b. On programme un mot de huit bits c'est-à-dire de huit cellules mémoires, en huit cycles différents.

Selon un mode de mise en oeuvre spécifique, la ligne de bits 15 d'une cellule mémoire (d'un rang donné) du mot 10 est jumelée avec une ligne de bits 34 d'une cellule mémoire (de préférence d'un même rang, afin d'éviter un enchevêtrement des connexions telles que 120, 121) du mot 70 directement adjacent horizontalement à ce premier mot 10. Le jumelage est réalisé par le circuit de multiplexage 33. Le circuit 33 aiguille la sortie 43 du circuit 32 sur l'une ou l'autre de ces lignes de bits 15 ou 34 en fonction d'une commande appliquée sur une connexion 71. La commande autorise la transmission du potentiel de programmation (ou d'inhibition) sur une seule de ces deux lignes de bits à la fois. En d'autres termes, on polarise soit la ligne de bits 15, soit la ligne de bits 34, et on programme donc soit la cellule 2, soit la cellule 35 appartenant au mot 70.

Le plan mémoire de la mémoire 1 est ainsi organisé en deux pages distinctes entrelacées. Une première page comporte le mot 10 et une deuxième page comporte le mot 70. Les deux pages comportant ainsi des groupes respectivement 72 et 81 de mots adjacents verticalement (figure 1). Le principe est qu'on programme successivement toutes les cellules d'un mot dans la première page puis toutes les cellules d'un mot dans la deuxième page. La commande appliquée sur la connexion 71 est donc changée une fois tous les huit cycles de programmation.

La raison de la présence du multiplexeur 33 est que les circuits 32 sont encombrants. Comme il en faut huit pour huit lignes de bits (pour programmer les cellules d'un mot de huit cellules), cela reviendrait à devoir espacer les lignes de bits 15 à 23 (figure 2). En introduisant les multiplexeurs 33, on peut loger le double de lignes de bits, celles du mot 10 et celles du mot 70, dans l'encombrement total des huit circuits de polarisation du groupe 75.

On a décrit un entrelacement de mots tels que 10 et 70. Il est cependant possible d'entrelacer directement les cellules. Dans ce cas, la cellule 35 serait placée à côté de la cellule 2 (à la place de la cellule 3 qui serait repoussée). Cette dernière manière de faire aurait l'avantage de réduire l'occupation de surface; il n'y aurait plus de connexion horizontale 120, 121 qui passent au dessus du mot 10 ou du mot 70. En pratique on réduirait la hauteur de quatorze épaisseurs de ces connexions 120, 121.

Avec le mode particulier de mise en oeuvre de l'invention décrit ci-dessus, on voit que le plan mémoire de la mémoire de type EPROM Flash réalisée peut comporter un nombre de ligne de bits deux fois supérieur au nombre de lignes de bits d'une mémoire EEPROM classique (par exemple 1024 lignes de bits sur une ligne de mot au lieu de 512). Dans une mémoire EEPROM classique, il existe un nombre de circuits de polarisation égal au nombre de ligne de bits. Dans le cas présent, le nombre de lignes de bits est double. Par ailleurs des spécifications quant aux mémoires EEPROM imposent de ne pas programmer plus de 64 lignes de bits à la fois. Dans l'invention, un circuit de multiplexage peut commander deux lignes de bits de même rang successivement, correspondant à deux mots adjacents horizontalement en entrelacement.

La programmation du plan mémoire de la mémoire 1 se réalise par une séquence d'opérations.

Au cours d'une première opération, on sélectionne des cellules telles que 2 à 9 d'un mot tel que le mot 10 d'une première page 72 par l'intermédiaire de la commande 71 du circuit de multiplexage 33.

Ensuite, de préférence, lors d'une deuxième opération on programme toutes les cellules 2 à 9 d'une même page à un même niveau permettant d'obtenir une tension de seuil uniforme pour chaque cellule de la page sélectionnée. Lors d'une troisième opération, on efface toutes les cellules sélectionnées 2 à 9. Lors de l'effacement, la tension de polarisation appliquée sur l'électrode de grille de commande d'un mot 10 est de l'ordre de - 6V. Toutes les cellules d'une même ligne de mots telle que 30 reçoivent cette tension, que la page soit sélectionnée ou non. D'autre part, l'électrode de source est portée à une tension de l'ordre de 10V. L'électrode de drain est portée à haute impédance. L'effacement nécessite une série de plusieurs impulsions de durées très brèves de l'ordre de 100*µ*s. Ces tensions, lors de l'effacement, peuvent provoquer d'une part une déplétion dans les cellules telles que 2 à 9 d'une page sélectionnée. Les cellules telle que la cellule 35 d'une page non sélectionnée reçoivent d'autre part sur leur électrode de grille de commande cette même tension - 6V. Cette tension négative cause des pertes de charges sur leur grille flottante et a tendance à les effacer quelque peu (on parle d'un effacement parasite).

Pour des cellules sélectionnées telles que 2 à 9 d'une page sélectionnée on vérifie avant toute programmation si les cellules ont subi une déplétion. Si c'est le cas on reprogramme celles-ci légèrement de façon à ce qu'elles retrouvent une tension de seuil devenue trop faible après l'effacement. De même, on va reprogrammer (on dit aussi rafraîchir) les cellules non sélectionnées telles que la cellule 35 d'une page non sélectionnée qui peuvent avoir subi un effacement parasite, c'est-à-dire une perte de charges, lors de l'effacement précédant la programmation des cellules 2 à 9 en raison de la forte tension appliquée sur la ligne de mots telle que la ligne de mots 30.

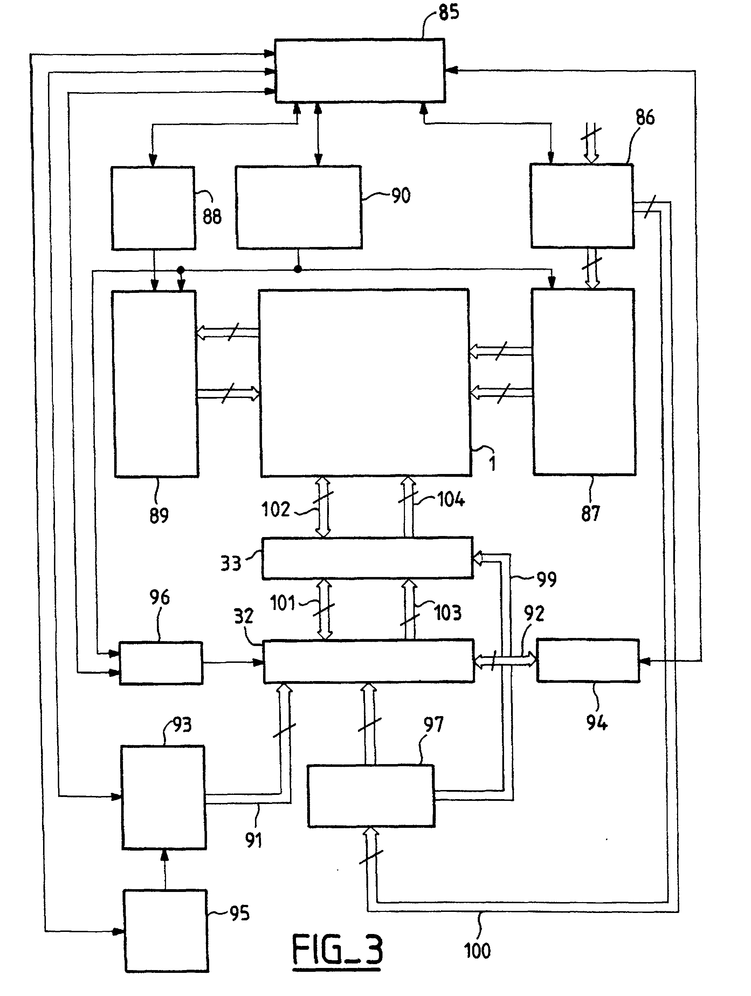

Sur la figure 3, on a représenté une mémoire 1 du type EPROM-Flash entourée de ses périphériques comportant symboliquement un circuit de polarisation 32 associé à un multiplexeur 33. La figure montre un microcontrôleur 85 permettant de commander le fonctionnement d'un compteur d'adresse 86. Ce compteur 86 permet d'adresser un décodeur de rangée 87. Ce compteur 86 comporte huit entrées et 256 sorties correspondant au nombre de lignes de mots existant dans la mémoire 1. Une pompe de charge de tension négative 88, commandée par le microcontrôleur 85, alimente un commutateur de tension 89 relié à la mémoire 1. Le commutateur 89 permet d'obtenir aussi bien une tension négative pour l'effacement, qu'une tension positive pour la programmation sur des lignes de mots sélectionnées par le décodeur 87.

Une pompe de charge 90, contrôlée par le microcontrôleur 85, permet d'alimenter le décodeur de ligne de mots 87, le commutateur de tension 89 et un commutateur de ligne de source 96. Un décodeur de ligne de bits 97 et le décodeur de ligne de mots 87 permettent d'appliquer sur les connexions de la mémoire 1 des potentiels représentatifs d'informations à enregistrer dans les cellules-mémoire ou représentatifs de commande d'écriture ou de lecture des informations dans les cellules. Le circuit de polarisation 32 est relié par ailleurs à un circuit de données à programmer 93 contrôlé par le microcontrôleur 85. Le circuit 93 fournit les données à programmer aux circuits 50 de délivrance. Le circuit 32 comporte à son entrée et à sa sortie des bus de données pour transporter des données lues et à écrire respectivement 92 et 91. Le bus 92 est relié à un circuit de lecture 94 contrôlé par le microcontrôleur 85. Le circuit 93 et le circuit 94 permettent de polariser les deux entrées respectivement 38 et 39 du circuit de polarisation 32, tant en écriture (programmation ou effacement) qu'en lecture. Pour des raisons pratiques, le circuit 93 est relié à une pompe de charge de drain 95 contrôlée par le microcontrôleur 85. La pompe 95 permet de fournir un courant élevé de l'ordre de 4mA (une cellule consommant un courant de l'ordre de 500µA) sur la connexion commune 38. Le circuit 95, 93, 91 permet de polariser la deuxième entrée 39 du circuit de polarisation 32.

Le circuit 32 est connecté à un bus de commande 99 provenant du décodeur de lignes de bits 97 et-délivrant un signal correspondant à l'une ou l'autre des deux pages à programmer. L'entrée de ce décodeur 97 de lignes de bits est aussi relié au compteur d'adresse 86 par un bus d'adresse 100. La sortie du circuit de polarisation 32 comporte un bus de données 101 avec un nombre de connexions correspondant au nombre total de circuits de polarisation 32 permettant la programmation de toute la mémoire, à savoir 512 circuits de polarisation. Dans un exemple cette mémoire 1 comporte 1024 lignes de bits.

Enfin le multiplexeur 33 est relié à la mémoire 1 par un bus d'adresse 102 dont le nombre de fils correspond au nombre de lignes de bits existant dans la mémoire A. Deux bus 103 et 104 permettent la sélection des lignes de source par envoi de signaux commande aux transistors 26.

La nouveauté de l'invention se trouve en particulier dans la présence du microcontrôleur 85 et dans les circuits 32, 33, 89, 93, 95 et 96. Le microcontrôleur 85 exécute un programme de programmation des cellules d'un même mot, les unes à la suite des autres, au cours de cycles de programmation successifs et différents. Ce programme met en oeuvre le procédé de programmation selon l'invention.

Dans ce qui précède, on a décrit un exemple de mise en oeuvre du procédé dans lequel on programme une cellule (M = 1) dans chacun des N mots. Cependant, dans le cas général, on peut programmer simultanément M cellules dans chaque mot, avec M différent de 1 et, toujours, M inférieur au nombre P de cellule d'un mot. Par exemple, on choisira M égal à deux (M = 2) ou M égal à quatre (M = 4) si P est égal à huit. Ceci permet une programmation plus rapide d'un mot de cellules mémoires. En effet, on sait qu'il faut P/M cycles de programmation pour programmer N mots de P cellules mémoires, soit respectivement quatre ou deux cycles dans les exemples ci-dessus.

## Revendications

1. Procédé de programmation d'une mémoire de type EPROM-Flash (1) comportant des mots de cellules mémoires arrangées en rangées (23) et en colonnes (31), dans lesquelles un transistor à grille flottante (7) agit comme organe de mémorisation, les transistors à grille flottante des cellules mémoires (2-9) d'un même mot (10) ayant leur grille de commande reliée à une même connexion de ligne de mots (30) et leur source reliée à une même électrode principale (29) d'un transistor de sélection (26) dont l'autre électrode principale (28) est reliée à une connexion verticale (25) de source de mots,
caractérisé en ce que, au cours d'un même cycle de programmation, on programme simultanément M cellules mémoires (2, 2b) dans N mots différents (10, 70), où M est inférieur au nombre P de cellules mémoires d'un mot, et où M, N et P sont des nombres entiers.

2. Procédé selon la revendication 1, caractérisé en ce que les N mots différents appartiennent à une même rangée de cellules mémoires.

3. Procédé selon la revendication 1 ou selon la revendication 2, caractérisé en ce que M est égal à l'unité.

4. Procédé selon la revendication 1 ou selon la revendication 2, caractérisé en ce que M est différent de l'unité, par exemple égal à deux ou à quatre si P est égal à huit.

5. Procédé selon l'une des revendications précédentes, caractérisé en ce que on programme toutes les cellules mémoires d'un mot déterminé au cours de P/M cycles de programmation successifs.

6. Procédé selon l'une des revendications précédentes, caractérisé en ce que les M cellules mémoires simultanément programmées dans les N mots différents sont des cellules de même rang dans lesdits mots.

7. Procédé selon l'une des revendications précédentes, caractérisé en ce que la programmation d'un mot déterminé de la mémoire comporte les opérations ou étapes suivantes:
- sélection de toutes les cellules du mot ;
- programmation de toutes lesdites cellules sélectionnées à un même niveau de tension de seuil;
- effacement de toutes lesdites cellules sélectionnées;
- vérification d'une éventuelle déplétion de certaines desdites cellules sélectionnées;
- si tel est le cas, reprogrammation légère de ces cellules sélectionnées déplétées afin d'amener leur tension de seuil à un niveau identique à celui des autres cellules effacées;
- programmation des cellules sélectionnées à programmer au cours de P/M cycles de programmation.

8. Procédé selon la revendication 7, caractérisé en ce que, les grilles de commande des transistors à grille flottante des cellules mémoires d'une même rangée étant connectées à une même ligne de mots et les grilles de commande des transistors de sélection des mots d'une même rangée étant connectées à une même ligne de sélection de mots, la programmation comporte en outre les ultimes opérations suivantes, dites opérations de rafraîchissement:
- vérification d'une éventuelle perte de charge des cellules mémoires non sélectionnées de la même rangée;
- et, si tel est le cas, reprogrammation légère de ces cellules mémoires afin de ramener leur tension de seuil à leur niveau précédent.

## Patentansprüche

1. Verfahren zum Programmieren eines Flash-EPROM-Speichers (1), der in Zeilen (23) und Spalten (31) angeordnete Speicherzellen für Worte umfasst, in denen ein Transistor mit schwimmendem Gate (7) als Speicherelement dient, wobei das Steuer-Gate der Transistoren der Speicherzellen (2-9) mit schwimmendem Gate eines selben Wortes (10) mit einer selben Wortleitungsverbindung (30) und ihre Source mit einer selben Haupt-Elektrode (29) eines Auswahltransistors (26) verbunden sind, dessen andere Haupt-Elektrode (28) mit einer vertikalen Source-Verbindung (25) von Worten verbunden ist,
dadurch gekennzeichnet, dass während eines Programmierzyklus' gleichzeitig M Speicherzellen (2, 2b) in N verschiedenen Wörtern (10, 70) programmiert werden, wobei M kleiner als die Anzahl P der Speicherzellen eines Wortes ist und M, N und P ganzzahlig sind.

2. Verfahren nach Anspruch 1, dadurch gekennzeichnet, dass die N verschiedenen Wörter zur selben Zeile von Speicherzellen gehören.

3. Verfahren nach Anspruch 1 oder 2, dadurch gekennzeichnet, dass M gleich eins ist.

4. Verfahren nach Anspruch 1 oder 2, dadurch gekennzeichnet, dass M ungleich eins ist und beispielsweise zwei oder vier beträgt, wenn P acht beträgt.

5. Verfahren nach einem der vorhergehenden Ansprüche, dadurch gekennzeichnet, dass alle Speicherzellen während P/M aufeinander folgenden Programmierzyklen mit einem bestimmten Wort programmiert werden.

6. Verfahren nach einem der vorhergehenden Ansprüche, dadurch gekennzeichnet, dass die M Speicherzellen, die gleichzeitig mit den N verschiedenen Wörtern programmiert werden, in diesen Wörtern Zellen von gleichem Rang sind.

7. Verfahren nach einem der vorhergehenden Ansprüche, dadurch gekennzeichnet, dass die Programmierung eines bestimmten Wortes des Speichers die folgenden Operationen oder Schritte umfasst:
- Auswahl aller Zellen des Wortes,
- Programmieren aller ausgewählten Zellen auf ein gleiches Schwellenspannungs-Niveau,
- Löschen aller ausgewählten Zellen,
- Überprüfen, ob bestimmte der ausgewählten Zellen leer sind,
- falls ja, schwache Neuprogrammierung dieser leeren ausgewählten Zellen, um ihre Schwellenspannung auf das gleiche Niveau wie bei den anderen gelöschten Zellen zu bringen,
- Programmieren der hierzu ausgewählten Zellen während P/M Programmierzyklen.

8. Verfahren nach Anspruch 7, dadurch gekennzeichnet, dass wenn die Steuer-Gates der Transistoren der Speicherzellen mit schwimmendem Gate einer selben Zeile mit derselben Wortzeile und die Steuer-Gates der Auswahltransistoren der Wörter einer selben Zeile mit einer selben Auswahlleitung von Wörtern verbunden sind, die Programmierung darüber hinaus am Schluss als die folgenden Operationen die so genannten Auffrischungs-Schritte umfasst:
- Überprüfen, ob die nicht-ausgewählten Speicherzellen derselben Zeile möglicherweise einen Ladungsverlust erlitten haben
- und, falls ja, schwache Neuprogrammierung dieser Speicherzellen, um ihre Schwellenspannung auf ihr vorheriges Niveau zurückzuführen.

## Claims

1. Method of programming a memory of EPROM-Flash type (1) including words of memory cells arranged in rows (23) and in columns (31), in which a floating-gate transistor (7) acts as memory-storage element, the floating-gate transistors of the memory cells (2-9) of the same word (10) having their control gate linked to the same word-line connection (30) and their source linked to the same main electrode (29) of a selection transistor (26) the other main electrode (28) of which is linked to a vertical word-source connection (25), characterised in that, in the course of the same programming cycle, M memory cells (2, 2b) are programmed simultaneously in N different words (10, 70), where M is less than the number P of memory cells of a word, and where M, N and P are integers.

2. Method according to Claim 1, characterised in that the N different words belong to the same row of memory cells.

3. Method according to Claim 1 or according to Claim 2, characterised in that M is equal to unity.

4. Method according to Claim 1 or according to Claim 2, characterised in that M is other than unity, for example equal to two or to four if P is equal to 8.

5. Method according to one of the preceding claims, characterised in that all the memory cells of a given word are programmed in the course of P/M successive programming cycles.

6. Method according to one of the preceding claims, characterised in that the M memory cells programmed simultaneously in the N different words are cells of the same rank in the said words.

7. Method according to one of the preceding claims, characterised in that the programming of a given word of the memory includes the following stages or operations:
- selection of all the cells of the word;
- programming of all the said selected cells at the same threshold-voltage level;
- erasing of all the said selected cells;
- checking for any depletion of some of the said selected cells;
- if such is the case, light re-programming of these depleted selected cells so as to bring their threshold voltage to a level identical to that of the other erased cells;
- programming of the selected cells to be programmed in the course of P/M programming cycles.

8. Method according to Claim 7, characterised in that, with the control gates of the floating-gate transistors of the memory cells of the same row being connected to the same word line and the control gates of the transistors for selecting words of the same row being connected to the same word-selection line, the programming further includes the following final operations, called refreshing operations:
- checking for any loss of charge of the non-selected memory cells of the same row;
- and, if such is the case, light re-programming of these memory cells so as to bring their threshold voltage back to their preceding level.
